# EUROPEAN PATENT APPLICATION

(11) **EP 4 571 856 A1**
(43) Date of publication of application: **18.06.2025**
(21) Application number: 23853053.9
(22) Date of filing: 11.08.2023
(51) Int. Cl.: H01L 33/54, H01L 33/58, H01L 33/44, H01L 25/075, H01L 27/15

(54) **LIGHT-EMITTING DEVICE AND DISPLAY APPARATUS INCLUDING SAME**

(30) Priority: 11.08.2022 US 202263397309 P; 10.08.2023 US 202318447456
(71) Applicant: Seoul Semiconductor Co., Ltd., Gyeonggi-do 15429 (KR)
(72) Inventor: LEE, Sangil, Ansan-Si Gyeonggi-do 15429 (KR)
(74) Representative: Stolmár & Partner Patentanwälte PartG mbB
(86) International application number: PCT/KR2023/011895
(87) International publication number: WO 2024/035186

(57) **Abstract**

A light emitting apparatus and a display apparatus including the same are disclosed. The light emitting apparatus includes at least one light emitting device and a first light control layer allowing light transmission therethrough and covering the light emitting device.

## Description

### [Technical Field]

The present invention relates to a light emitting apparatus, more particularly to a light emitting apparatus using light emitting diode chips and a display apparatus including the same.

### [Background Art]

Various light emitting apparatuses are applied to various display apparatuses, such as TVs, computer monitors, smartphones, smart pads, and the like.

Such a light emitting apparatus is disposed as a light source at the backside of a display panel to emit light towards a backlight unit, that is, the display panel. For a direct-emission type backlight unit, multiple light emitting diodes are disposed as light sources at the backside of the display panel and covered with a molding material to allow light to spread to the display panel. However, a typical light emitting apparatus has a limit in control of thickness uniformity of the molding material covering the light emitting diodes and thus suffers from low controllability with respect to light and deterioration in luminance due to difficulty in proper control of surface leveling.

### [Disclosure]

### [Technical Problem]

Embodiments of the present invention provide a light emitting apparatus that has high controllability with respect to light emitted therefrom and can prevent color mixing while improving luminance, and a display apparatus including the same.

Specifically, embodiments of the present invention provide a light emitting apparatus that allows uniform emission of light through a light control layer covering light emitting devices and can improve light extraction efficiency.

In addition, embodiments of the present invention provide a light emitting apparatus that allows surface roughness of the light control layer covering the light emitting devices to be controlled in the range of several micrometers to maximize luminance through improvement in surface level of the light control layer.

### [Technical Solution]

In accordance with one aspect of the present invention, a light emitting apparatus includes: at least one light emitting device; and a first light control layer allowing light transmission therethrough and covering the light emitting device, wherein the first light control layer has at least one protrusion formed in at least some region on an upper surface thereof and a height difference G1 between the maximum height and the minimum height of the at least one protrusion is 40 µm or less.

In accordance with another aspect of the present invention, a display apparatus includes: a substrate; at least one light emitting device disposed on one surface of the substrate; and a first light control layer covering at least part of the light emitting device, wherein the first light control layer has at least one protrusion formed in at least some region on an upper surface thereof and a height difference G1 between the maximum height and the minimum height of the at least one protrusion is 40 µm or less.

In accordance with a further aspect of the present invention, a display apparatus includes: a substrate; at least one light emitting device disposed on one surface of the substrate; and a first light control layer covering at least part of the light emitting device, wherein the first light control layer is formed with a slanted surface or a curved surface in at least some region thereof.

### [Advantageous Effects]

The present invention provides a light emitting apparatus that has high controllability with respect to light emitted therefrom and can prevent color mixing while improving luminance, and a display apparatus including the same.

The present invention provides a light emitting apparatus that allows uniform emission of light through a light control layer covering light emitting devices and can improve light extraction efficiency.

The present invention provides a light emitting apparatus that allows surface roughness of the light control layer covering the light emitting device to be controlled in the range of several micrometers to maximize luminance through improvement in surface level of the light control layer.

### [Description of Drawings]

FIG. 1A is a sectional view of a light emitting apparatus according to a first embodiment of the present invention.
FIG. 1B is a sectional view of a light emitting apparatus according to an exemplary embodiment of the present invention.
FIG. 2A is a sectional view of a light emitting apparatus according to a second embodiment of the present invention.
FIG. 2B and FIG. 2C are sectional views of a light emitting apparatus according to an exemplary embodiment of the present invention.
FIG. 3A is a sectional view of a light emitting apparatus according to a third embodiment of the present invention.
FIG. 3B is a sectional view of a light emitting apparatus according to an exemplary embodiment of the present invention.
FIG. 4A is a sectional view of a light emitting apparatus according to a fourth embodiment of the present invention.
FIG. 4B is a sectional view of a light emitting apparatus according to an exemplary embodiment of the present invention.
FIG. 5 is a sectional view of a light emitting apparatus according to a fifth embodiment of the present invention.
FIG. 6A is a sectional view of multiple light emitting apparatuses according to a sixth embodiment of the present invention.
FIG. 6B and FIG. 6C are sectional views of multiple light emitting apparatuses according to exemplary embodiments of the present invention.

### [Best Mode]

The present invention may be modified in various ways and may have various forms, and exemplary embodiments will be described in detail with reference to the accompanying drawings. However, it should be understood that the present invention is not limited to particular embodiments disclosed herein and includes all modifications, equivalents and substitutions within the spirit and scope of the present invention.

The present invention provides a light emitting apparatus that includes: a light emitting device including at least one light emitting diode chip; and a first light control layer allowing light transmission therethrough and covering at least part of the light emitting device.

The first light control layer may include a light transmissive material and one surface of the first control layer may have different heights in at least some regions thereof. Specifically, a height difference between a maximum height (height of the highest surface) and a minimum height (height of the lowest surface) on an upper surface of the first light control layer corresponding to the one surface thereof may be 40 µm or less.

In addition, the first light control layer may cover at least some region of a side surface of the light emitting device that generates and emits light, and may include a light reflective material. Here, the first light control layer may be disposed so as not to cover an upper surface of the light emitting device while covering at least some region on the side surface of the light emitting device.

The light emitting apparatus may further include a second light control layer on the first light control layer and the light emitting device. The second light control layer may include a light diffusive material.

When the light emitting apparatus is provided in plural, a first light emitting apparatus and a second light emitting apparatus may be disposed side by side in a lateral direction thereof. Here, an angle of 40° or less is defined at an interface between the first light emitting apparatus and the second light emitting apparatus.

Hereinafter, exemplary embodiments of the present invention will be described in detail with reference to the accompanying drawings.

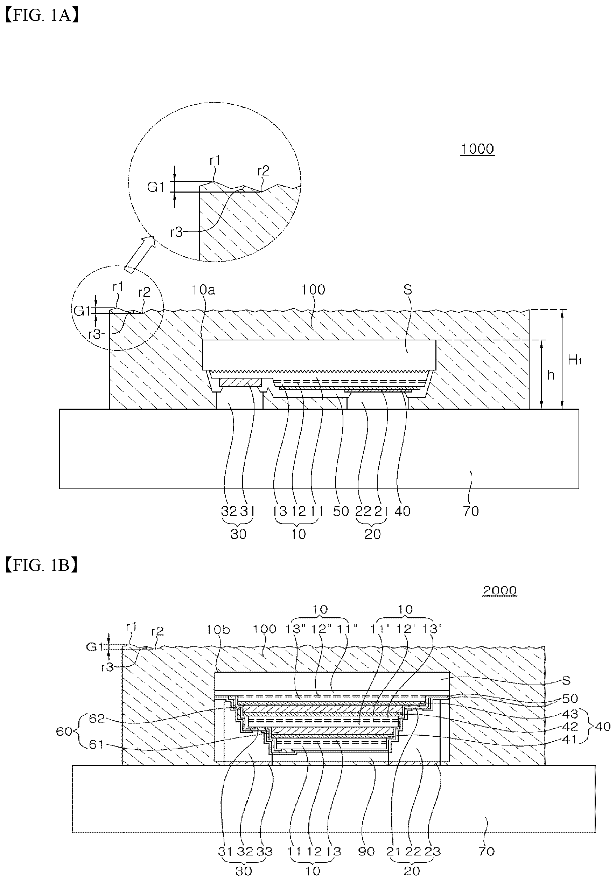

FIG. 1A and FIG. 1B shows a light emitting apparatus 1000; 2000 according to a first embodiment of the invention. The light emitting apparatus 1000; 2000 according to this embodiment may include at least one light emitting device 10a and a first light control layer 100 covering at least part of the light emitting device 10a. The light emitting apparatus 1000; 2000 may further include a substrate 70 having a conductive pattern and the light emitting device 10a may be disposed on one surface of the substrate 70 to be electrically connected to the substrate 70.

The first light control layer 100 may be formed by depositing a sheet type molding material and liquefying the molding material through treatment at high temperature, followed by pressing the liquefied molding material in a direction of a light emitting unit 10a. Alternatively, the first light control layer 100 may be a layer formed through UV curing of a resin.

The sheet type molding material may be a molding material in a semi-cured state of a thermosetting resin or a UV curable resin, in an intermediate stage of curing reaction thereof, or in a state prior to a completely cured state thereof.

The thermosetting resin includes polymers not allowing crosslinking reaction by heat and thus can exhibit flowability or become soft through increase in dynamic energy of the polymers upon application of heat. Accordingly, after the molding material is deposited onto the light emitting device 10a, the molding material is pressed in the direction of the light emitting device 10a at high temperature to form a mold in which a surrounding region of the light emitting device 10a is filled with the molding material.

Referring to FIG. 1A, the first light control layer 100 may be a light transmissive layer formed of a light transmissive material and may be disposed to cover at least part of the light emitting device 10a.

The first light control layer 100 may have a light transmittance of 50% or more, preferably 70% or more. Here, the first light control layer 100 may have a light blocking rate of 40% or less.

In addition, the first light control layer 100 may cover not only a side surface of the light emitting device 10a but also an upper surface of the light emitting device 10a. Accordingly, the first light control layer 100 may have a greater height H1 than a height h of the light emitting device 10a. Here, the height h of the light emitting device 10a may be 0.5 times or more, more preferably 0.6 times to 0.8 times, of the height H1 of the first light control layer 100.

Here, the height H1 of the first light control layer 100 refers to a length from the lowermost end of the first light control layer 100 to an upper surface of the first light control layer 100 and the first light control layer 100 may have the maximum height or the minimum height depending on formation of protrusion on the upper surface thereof, as described below.

As a reference for measurement of the height H1 of the first light control layer 100, the lowermost end of the first light control layer 100 may correspond to an upper surface of the substrate 70 on which the light emitting device 10a is disposed.

Likewise, the height h of the light emitting device 10a refers to a length from the lowermost end of the light emitting device 10a to the uppermost end of the light emitting device 10a, and, as a reference for measurement of the height h of the light emitting device 10a, the lowermost end of the light emitting device 10a may correspond to the upper surface of the substrate 70 on which the light emitting device 10a is disposed.

In addition, the first light control layer 100 may have a greater width than the light emitting unit 10a.

The first light control layer 100 may have at least one protrusion formed in at least some region on the upper surface thereof. The protrusion may constitute a rough upper surface of the first light control layer 100 and may be provided in plural.

Although FIG. 1A shows an example of the protrusion having a triangular conical shape, it should be understood that the present invention is not limited thereto and the protrusion may be formed in various shapes, such as a rectangular shape, a hemispherical shape, and the like. In addition, when the protrusion is provided in plural, the multiple protrusions may have different shapes and sizes.

By the protrusions, slanted round surfaces may be irregularly formed on the upper surface of the first light control layer 100 to have a predetermined angle r3 with respect to a horizontal surface, in which the predetermined angle r3 may be one of irregular angles. However, it should be understood that the present invention is not limited thereto and at least some region on the upper surface of the first light control layer 100 may form a flat surface on which the predetermined angle r3 is 0.

The irregular roughnesses may be formed on the upper surface of the first light control layer 100 by the slanted round surfaces slanted at an angle r3.

As the slanted round surfaces are formed in at least some region on the upper surface of the first light control layer 100 by the protrusions thereon, the surface of the first light control layer 100 may form the highest surface r1 and the lowest surface r2.

The highest surface r1 and the lowest surface r2 of the first light control layer 100 may be formed by the protrusions thereof.

By way of example, the highest surface r1 and the lowest surface r2 may be surfaces formed by the same protrusion and may be placed adjacent each other. That is, the highest surface r1 and the lowest surface r2 may be placed adjacent each other with one slanted surface therebetween.

In another example, as the multiple protrusions are formed on the upper surface of the first light control layer 100, the highest surface r1 and the lowest surface r2 of the first light control layer 100 may be formed by different protrusions and may be spaced apart from each other. That is, referring to FIG. 1A, as the highest surface r1 and the lowest surface r2 are formed by different protrusions, the highest surface r1 and the lowest surface r2 may be spaced apart from each other with multiple slanted surfaces therebetween.

A distance between the highest surface r1 and the lowest surface r2 on the upper surface of the first light control layer 100 may be set in various ways.

A height difference G1 between the highest surface r1 and the lowest surface r2 on the upper surface of the first light control layer 100 indicates a surface leveling degree of the first light control layer 100.

The leveling degree on the upper surface of the first light control layer 100 may be improved by pressing the first light control part 100 through the molding material.

The height difference G1 (= r1-r2) between the maximum height (height of the highest surface r1) and the minimum height (height of the lowest surface r2) of the upper surface of the first light control layer 100 may be 40 µm or less.

By way of example, the height difference G1 may range from 2 µm to 30 µm, more preferably 10 µm or less.

According to the present invention, the surface leveling degree of the first light control layer 100 may be managed to within several micrometers, thereby effectively improving brightness or uniformity of luminance of light emitted per unit area from the surface of the first light control layer 100.

A greater height difference G1 between the highest surface r1 and the lowest surface r2 of the first light control layer 100 may indicate greater roughnesses and a lower surface leveling degree. For example, when the height difference G1 is greater than 40 µm, a luminance deviation of light emitted from the light emitting device 10a may be 5% or more.

That is, a lower height difference G1 between the highest surface r1 and the lowest surface r2 of the first light control layer 100 may indicate lower roughnesses and a higher surface leveling degree. For example, when the height difference G1 is equal to or less than 40 µm, a luminance deviation of light emitted from the light emitting device 10a may be 5% or less. In addition, when the height difference G1 ranges from 2 µm to 30 µm, a luminance deviation of the light emitting device 10a may range from 2% to 3%.

Accordingly, a display apparatus including the first light control layer 100 can improve deviation in luminance of light emitted from the first light control layer 100 through management of the leveling degree of the first light control layer 100.

Specifically, for the light emitting apparatus according to the present invention, the luminance deviation of light emitted from the light emitting apparatus and having passed through first light control layer 100 may be set to 5% or less, substantially within the range of 2% to 3%. A lower luminance deviation secures better uniformity of light emitted towards a display panel, thereby improving visibility of the display apparatus.

That is, the light emitting apparatus 1000 according to the first embodiment can effectively improve luminance uniformity of a display apparatus through the first light control layer 100. As such, the present invention can realize a high luminance display apparatus by providing a light emitting apparatus having a low luminance deviation. Luminance is an indicator of brightness per unit area in a display and the present invention can realize a display apparatus with uniform brightness over the entire display region thereof, that is, high luminance uniformity.

Referring to FIG. 1A, the light emitting device 10a serves to generate and emit light and may include a first conductivity type semiconductor layer 11, an active layer 12 and a second conductivity type semiconductor layer 13 on a substrate S.

Further, the light emitting device 10a may be at least one light emitting diode chip that includes a lower contact layer 40 including a transparent conductive material allowing light transmission therethrough, an insulating layer 50, a P electrode pad 21 electrically connected to the second conductivity type semiconductor layer, and an N electrode pad 31 electrically connected to the first conductivity type semiconductor layer.

The light emitting diode chip of the light emitting device 10a may include a first connection electrode 32 and a second connection electrode 22. At least part of the first connection electrode 32 may be formed on the first conductivity type semiconductor layer to be electrically connected to the N electrode pad 31 and at least part of the second connection electrode 22 may be formed on the second conductivity type semiconductor layer to be electrically connected to the P electrode pad 21.

The N electrode pad 31 may be electrically connected to the first connection electrode 32 to be electrically connected to a printed circuit board (PCB). The P electrode pad 21 may be electrically connected to the second connection electrode 22 to be electrically connected to the printed circuit board (PCB).

However, it should be understood that the present invention is not limited thereto and the first and second electrode pads 21, 31 may be directly electrically connected to the PCB without the first and second connection electrodes 22, 32.

According to an exemplary embodiment, the light emitting apparatus may include multiple light emitting devices 10a, which may be arranged in various ways. For example, the light emitting apparatus may include three light emitting devices 10a, that is, three light emitting diodes, which may be arranged side by side in a lateral direction. More specifically, a light emitting device 10a emitting red light, a light emitting device 10a emitting green light, and a light emitting device 10a emitting blue light may be arranged in the lateral direction. According to this embodiment, the light emitting apparatus can realize RGB trichromatic colors through pixels.

The light emitting device 10a emitting red light may be a red light emitting diode having a peak wavelength in the red wavelength band, in which the red light emitting diode may have a difference of 5 nm to 20 nm between the peak wavelength and a dominant wavelength thereof. Specifically, the red light emitting diode may have a peak wavelength in the range of 620 nm to 640 nm and a dominant wavelength in the range of 610 nm to 630 nm. The peak wavelength of the red light emitting diode may be a longer wavelength than the dominant wavelength thereof.

The light emitting device 10a emitting green light may be a green light emitting diode having a peak wavelength in the green wavelength band, in which the green light emitting diode may have a difference of 5 nm to 20 nm between the peak wavelength and a dominant wavelength thereof. Specifically, the green light emitting diode may have a peak wavelength in the range of 520 nm to 540 nm and a dominant wavelength in the range of 525 nm to 545 nm. The peak wavelength of the green light emitting diode may be a longer wavelength than the dominant wavelength thereof.

The light emitting device 10a emitting blue light may be a blue light emitting diode having a peak wavelength in the blue wavelength band, in which the blue light emitting diode may have a difference of 2 nm to 15 nm between the peak wavelength and a dominant wavelength thereof. Specifically, the blue light emitting diode may have a peak wavelength in the range of 455 nm to 475 nm and a dominant wavelength in the range of 460 nm to 480 nm. The peak wavelength of the blue light emitting diode may be a longer wavelength than the dominant wavelength thereof.

In the light emitting apparatus including a red light emitting diode, a green light emitting diode and a blue light emitting diode, the light emitting diodes may have different deviations between the peak wavelengths and the dominant wavelengths. For example, a deviation between the peak wavelength and the dominant wavelength of the blue light emitting diode may be smaller than a deviation between the peak wavelength and the dominant wavelength of the green light emitting diode. A deviation between the peak wavelength and the dominant wavelength of the green light emitting diode may be smaller than a deviation between the peak wavelength and the dominant wavelength of the red light emitting diode. As such, it is possible to improve color purity and visibility of colors realizing an image of the display by controlling the deviations between the peak wavelengths and the dominant wavelengths of the blue light emitting diode, the green light emitting diode, and the blue light emitting diode in the light emitting apparatus.

The light emitting device 10a emitting red light may include at least one light emitting diode and a red wavelength converter excited by light emitted from the light emitting diode to emit red light. The red wavelength converter may include inorganic or organic phosphors or quantum dots.

The red wavelength converter may have a full width at half maximum of 30 nm or less, specifically 20 nm or less. The red wavelength converter may have a wavelength conversion rate of 70% or more.

The light emitting device 10a emitting green light may include at least one light emitting diode and a green wavelength converter excited by light emitted from the light emitting diode to emit green light. The green wavelength converter may include inorganic or organic phosphors or quantum dots. The green wavelength converter may have a full width at half maximum of 30 nm or less, specifically 20 nm or less. The green wavelength converter may have a wavelength conversion rate of 70% or more.

The light emitting device 10a emitting blue light may include at least one light emitting diode and a blue wavelength converter excited by light emitted from the light emitting diode to emit blue light. The blue wavelength converter may include inorganic or organic phosphors or quantum dots. The blue wavelength converter may have a full width at half maximum of 30 nm or less, specifically 20 nm or less. The blue wavelength converter may have a wavelength conversion rate of 70% or more.

The light emitting device 10a may be composed of the red, green and blue light emitting diodes, thereby realizing trichromatic colors. Alternatively, the light emitting device 10a may include the wavelength converter in at least one light emitting diode, thereby realizing trichromatic colors.

FIG. 1B is a sectional view of another exemplary embodiment of the light emitting apparatus shown in FIG. 1A. A light emitting apparatus 2000 shown in FIG. 1B has the same configuration as the light emitting apparatus 1000 shown in FIG. 1A excluding the configuration and shape of the light emitting device 10b.

According to the exemplary embodiment, a light emitting device 10b may be a stack type semiconductor layer formed by stacking three light emitting diodes. The stack type semiconductor layer may include a first light emitting stack 10, a second light emitting stack 20 and a third light emitting stack 30. The second light emitting stack 20 may be disposed on the first light emitting stack 10 and the third light emitting stack 30 may be disposed on the second light emitting stack 20, in which each of the first to third light emitting stacks 10, 20, 30 may include a first conductivity type semiconductor layer 11; 11'; 11", an active layer 12; 12'; 12", and a second conductivity type semiconductor layer 13; 13'; 13".

In addition, the light emitting device 10b may include a bonding layer 60, which bonds the first to third light emitting stacks 10, 20, 30 to each other, a lower contact layer 40, an insulating layer 50, and P and N electrode pads 21, 31. The P and N electrode pads 21, 31 may be electrically connected to a PCB substrate through connection electrodes 22, 32 connected thereto.

The first to third light emitting stacks 10, 20, 30 may include a red light emitting stack, a green light emitting stack, and a blue light emitting stack, respectively. Accordingly, the stack type light emitting unit 10b including the first to third light emitting stacks 10, 20, 30 can realize RGB trichromatic colors through pixels.

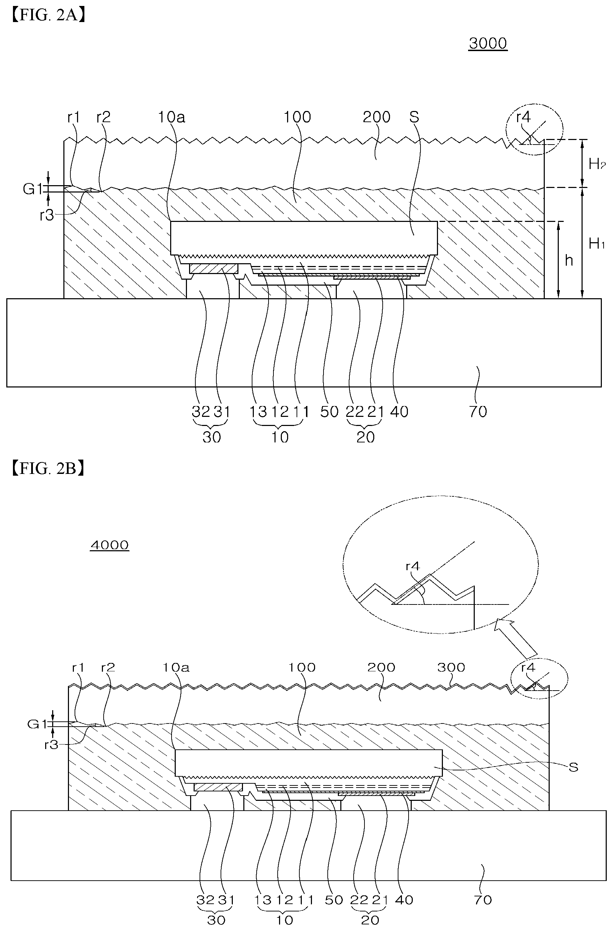

Next, FIG. 2A is a sectional view of a light emitting apparatus 3000 according to a second embodiment of the present invention.

Referring to FIG. 2A, the light emitting apparatus 3000 according to the second embodiment may include a light emitting device 10a and a second light control layer 200 disposed on a first light control layer 100 and allowing light transmission therethrough.

In FIG. 2A, the shapes and features of the light emitting device 10a and the first light control layer 100 are the same as those of the first embodiment described above and detailed description thereof will be omitted. In addition, although not shown in the drawings, the light emitting device 10a disposed inside the first light control layer 100 may be a stack type semiconductor layer including the first to third light emitting stacks, like the light emitting device 10b shown in FIG. 1B.

The second light control layer 200 may have at least one protrusion formed in some region on an upper surface thereof. The protrusion may form a rough upper surface of the second light control layer 200 and may be provided in plural.

Although FIG. 2A shows an example of the protrusion having a triangular conical shape, it should be understood that the present invention is not limited thereto and the protrusion may be formed in various shapes, such as a rectangular shape, a hemispherical shape, and the like. In addition, when the protrusion is provided in plural, the multiple protrusions may have different shapes and sizes.

By the protrusions, one surface of the second light control layer 200 may have a round shape in at least some region thereof. Specifically, the second light control layer 200 may have slanted round surfaces having a predetermined angle and formed in at least some region on an upper surface thereof.

The predetermined angle r4 may be one of irregular angles and may be irregularly formed on the surface of the second light control layer 200. However, it should be understood that the present invention is not limited thereto and at least some region on the upper surface of the second light control layer 200 may form a flat surface on which the predetermined angle r4 is 0.

As the slanted round surfaces having a predetermined angle r4 are formed in at least some region on the upper surface of the second light control layer 200 by the protrusions thereon, the surface of the second light control layer 200 may be formed with irregular roughnesses.

The roughnesses on the upper surface of the second light control layer 200 may be greater than the roughnesses on the upper surface of the first light control layer 100. That is, the predetermined angle r4 defined by the slanted surfaces on the upper surface of the second light control layer 200 may be greater than the predetermined angle r3 defined by the slanted surfaces on the upper surface of the first light control layer 100.

The second light control layer 200 may include a light transmissive material and a light diffusive material. The second light control layer 200 may have a different light transmittance than the first light control layer 100. The second light control layer 200 may have a different light blocking rate than the first light control layer 100. More preferably, the second light control layer 200 has a higher light transmittance than the first light control layer 100 and a lower light blocking rate than the first light control layer 100.

The second light control layer 200 is a light diffusive layer and may be formed of a translucent or transparent material. Accordingly, when light generated from the light emitting device 10a is emitted upwards, the second light control layer 200 allows emission of light therethrough after spreading the light therein.

For example, in a display apparatus, light can evenly spread to the entirety of a display panel through the second light control layer 200. Light generated and emitted from multiple light emitting devices 10a may be delivered to the second light control layer 200 and may spread from the back surface of the second light control layer 200 towards a front surface (upper surface) thereof in an outward direction of the display apparatus.

In addition, the second light control layer 200 may exhibit different light transmittances depending on the content of light diffuser for spreading light therein. Accordingly, the thickness H2 of the second light control layer 200 may be set in the range of, for example, 50 µm to 300 µm, in consideration of light transmittance. Here, the thickness H2 of the second light control layer 200 may be greater than a length (H1-h) from the top of the light emitting device 10a to the upper surface of the first light control layer 100.

FIG. 2B is a sectional view of another exemplary embodiment of the light emitting apparatus show in FIG. 2A.

Referring to FIG. 2B, a light emitting apparatus 4000 may further include a third light control layer 300 on the second light control layer 200.

The third light control layer 300 is an anti-glare layer and may have at least one protrusion formed in at least some region on an upper surface thereof. The protrusion forms a rough upper surface of the third light control layer 200 and may be provided in plural.

As the third light control layer 300 is disposed on the second light control layer 200, the protrusions formed on the upper surface of the third light control layer 300 may have the same shape as or a similar shape to the protrusions formed on the upper surface of the second light control layer 200.

By way of example, the third light control layer 300 may have a round shape formed in at least some region on the upper surface thereof and having a predetermined angle r4. As such, the protrusions formed on one surface of the third light control layer 300 provides an anti-glare function to the third light control layer 300. In addition, the predetermined angle r4 may be one of irregular angles and may be irregularly formed on the surface of the third light control layer 300.

Further, the third light control layer 300 may be a film layer formed through matte treatment. For example, the third light control layer 300 may be an anti-glare film layer formed by attaching a matte film to an upper surface of the second light control layer 200, followed by surface treatment of the second light control layer 200.

The thickness of the third light control layer 300 may be much smaller than the second light control layer 300 and may be, for example, 1 µm or less. However, it should be understood that the present invention is not limited thereto and the third light control layer 300 may have various thicknesses depending on the thickness of the film attached to the upper surface of the second light control layer 200.

A bonding layer for attachment of the film may be formed between the third light control layer 300 and the second light control layer 200.

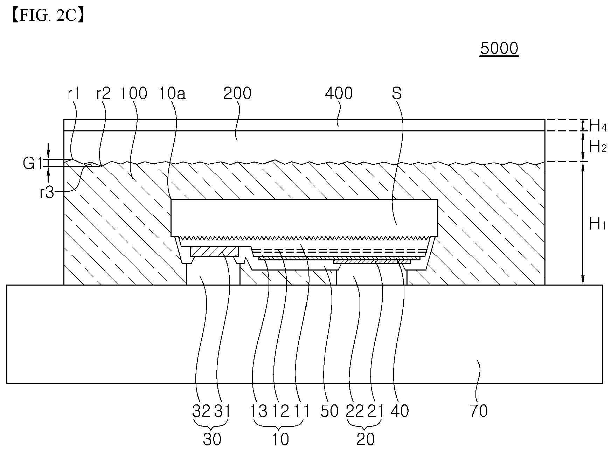

FIG. 2C is a sectional view of a further exemplary embodiment of the light emitting apparatus shown in FIG. 2A.

Referring to FIG. 2C, a light emitting apparatus 5000 may include a light emitting device 10a, a first light control layer 100, and a second light control layer 200, and may further include an anti-glare layer 400 on an upper surface of the second light control layer 200 instead of the third light control layer 300.

In FIG. 2C, the shapes and features of the light emitting device 10a, the first light control layer 100, and the second light control layer 200 are the same as those of the first embodiment described above and detailed description thereof will be omitted. Although not shown in the drawings, the light emitting device 10a disposed inside the first light control layer 100 may be a stack type semiconductor layer including the first to third light emitting stacks, like the light emitting device 10b shown in FIG. 1B. In addition, although FIG. 2C is distinguished from FIG. 2A and FIG. 2B in that the second control part 200 is not formed with roughnesses on the upper surface thereof, the light emitting apparatus 5000 may have the same shape and features as those shown in FIG. 2A to FIG. 2B.

The anti-glare layer 400 is a layer for preventing eye glare and may have a function similar to the third light control layer 300 of the second embodiment. A thickness H4 of the anti-glare layer 400 may be greater than the thickness of the third light control layer 300 and may be thinner than the thickness H2 of the second light control layer 200 disposed under the anti-glare layer 400.

In addition, the anti-glare layer 400 may be formed by attaching, for example, an anti-glare (AG) film or by coating an anti-glare (AG) coating solution. However, it should be understood that the present invention is not limited thereto and the anti-glare layer 400 may be formed of any material capable of preventing eye glare.

For the anti-glare layer 400 formed by attaching an AG film, the light emitting apparatus 5000 may further include a bonding layer for attaching the AG film to the second light control layer 200.

In FIG. 2C, as the anti-glare layer 400 is disposed on the upper surface of the second light control layer 200, an upper surface of the anti-glare layer 400 may form a flat surface with no roughness. However, it should be understood that the present invention is not limited thereto and that the second light control layer 200 and the anti-glare layer 400 may have irregularity (roughnesses) on the upper surfaces thereof.

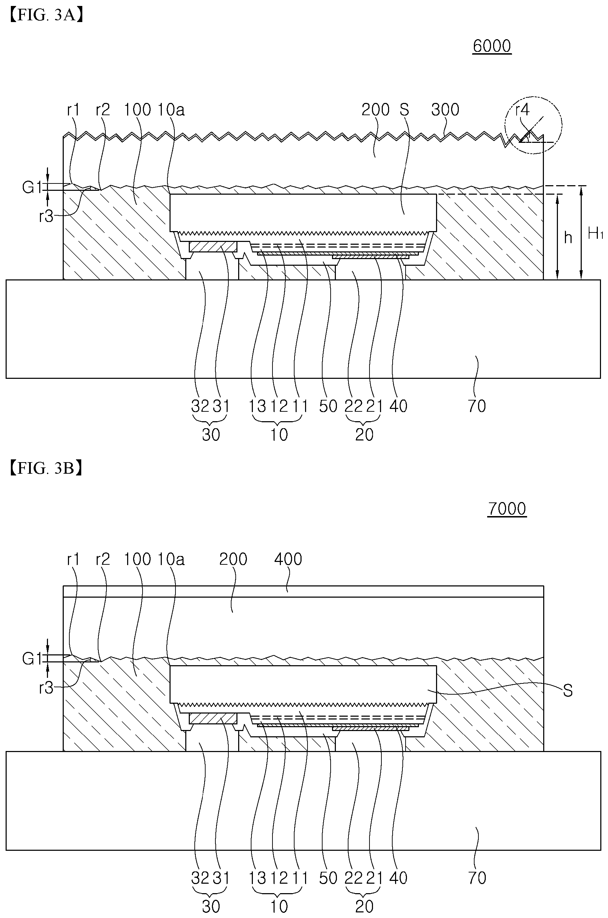

Next, FIG. 3A is a sectional view of a light emitting apparatus 6000 according to a third embodiment of the present invention.

In the light emitting apparatuses according to the first and second embodiments, the first light control layer 100 has a much greater height than the light emitting device 10a so as to completely cover the upper surface of the light emitting unit 10a through a predetermined thickness thereof. However, in the light emitting apparatus 6000 according to the third embodiment, the first light control layer 100 may be formed to have a slightly greater height H1 than or a similar thickness to the height h of the light emitting device 10a so as to cover the upper surface of the light emitting device 10a through a thin thickness thereof.

Specifically, referring to FIG. 3A, in the light emitting apparatus 6000 according to the third embodiment, the height H1 of the first light control layer 100 may be similar to or slightly greater than the height h of the light emitting device 10a.

For example, the first light control layer 100 may cover the upper surface of the light emitting device 10a through a smaller thickness than a height difference G1 between the highest surface r1 and the lowest surface r2 on the upper surface of the first light control layer 100. That is, a thickness (H1-h) from the upper surface of the light emitting device 10a to the upper surface of the first light control layer 100 may be smaller than the height difference G1. However, it should be understood that the present invention is not limited thereto and that the first light control layer 100 may cover the upper surface of the light emitting device 10a through a slightly greater thickness than the height difference G1 between the highest surface r1 and the lowest surface r2 on the upper surface of the first light control layer 100.

Since the features and upper surface morphology of the light emitting devices 10a, 10b and the first light control layer 100 of the light emitting apparatus 6000 according to the third embodiment are the same as those of the first and second embodiments, detailed description thereof will be omitted herein. Further, since the third light control layer 300 may be disposed on the second light control layer 200 and the features and shape of the third light control layer 300 according to the third embodiment are the same as those of the third light control layer 300 according to the second embodiment, detailed description thereof will be omitted herein.

Referring to FIG. 3A, according to the third embodiment, since the first light control layer 100 may be formed to a height H1, which is similar to or slightly greater than the height h of the light emitting device 10a, so as to thinly cover the upper surface of the light emitting device 10a, a traveling path of light emitted upwards from the light emitting device 10a and traveling to the second light control layer 200 can be significantly reduced. In other words, since the traveling path of light emitted upwards from the light emitting device 10a and traveling in the first light control layer 100 is reduced, the light can be rapidly emitted to the second light control layer 200 corresponding to the light spreading layer. Accordingly, light emitted from the light emitting device 10a can rapidly reach the second light control layer 200 and can be spread thereby, thereby improving light extraction efficiency.

FIG. 3B is a sectional view of another exemplary embodiment of the light emitting apparatus shown in FIG. 3A.

Referring to FIG. 3B, in a light emitting apparatus 7000, a first light control layer 100 may have a similar height H1 to or a slightly greater height H1 than the height h of a light emitting device 10a, like the light emitting apparatus 6000 shown in FIG. 3A. The light emitting apparatus 7000 may include an anti-glare layer 400 on the second light control layer 200 instead of the third light control layer 300.

The anti-glare layer 400 may be the same as or similar to that of the second embodiment and thus detailed description thereof will be omitted herein.

Although not shown in the drawings, the light emitting device 10a may be a light emitting device 10b to which a stack type semiconductor layer including first to third light emitting stacks is applied. Since the features and upper surface morphology of the first light control layer 100 and the detailed description of the second light control layer 200 and the light emitting devices 10a, 10b are the same as those described above, detailed description thereof will be omitted.

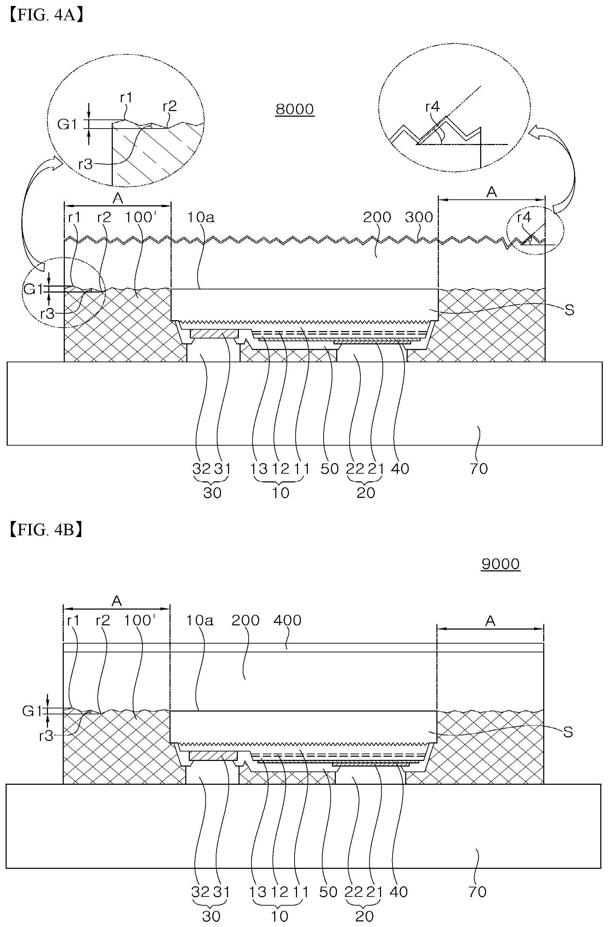

FIG. 4A is a sectional view of a light emitting apparatus 8000 according to a fourth embodiment of the present invention.

Referring to FIG. 4A, according to the fourth embodiment, the light emitting apparatus 8000 includes a first light control layer 100', which may further include a light reflective material or a light absorbing material, unlike the first light control layer 100 according to the first to third embodiments.

The first light control layer 100' may be an opaque layer and may include a black pigment to adjust contrast of a display apparatus. Here, like the first light control layer 100 according to the first to third embodiments, the first light control layer 100' according to the fourth embodiment may be formed by depositing a molding material on the light emitting device 10a and liquefying the molding material through compression and treatment at high temperature such that a surrounding portion of the light emitting device 10 can be filled with the molding material. In addition, the first light control layer 100' may be a layer formed through UV curing of a resin.

In the fourth embodiment, the first light control layer 100' may have at least one protrusion formed in at least some region on the upper surface thereof and the protrusion on the upper surface of the first light control layer 100' may be the same as or similar to the protrusion formed on the first light control layers 100 according to the first to third embodiments. That is, the first light control layer 100' may include round regions in at least some region on the upper surface thereof. The first light control layer 100' may include slanted regions in at least some region on the upper surface thereof.

The shape, features and operation of the first light control layer 100' according to the fourth embodiment are the same as those of the first light control layer 100 according to the first to third embodiments and thus detailed description thereof will be omitted herein.

According to the fourth embodiment, the first light control layer 100' may have a light blocking function and may perform both the light blocking function and a light reflection function. For example, the first light control part 100' may be formed of a carbon black molding material or a molding material prepared by combination of black and white molding materials.

However, it should be understood that the present invention is not limited thereto and the first light control layer 100' may further have the light reflective function in addition to the light blocking function. For example, the first light control layer 100' may be formed of a white molding material or a molding material prepared by combination of black and white molding materials. Accordingly, the light emitting apparatus can adjust contrast of light emitted through the first light control part 100', thereby improving luminance of the display apparatus.

As the first light control layer 100' includes at least one selected from among the light blocking material and the light reflective material, the first light control layer 100' may expose at least part of the upper surface of the light emitting device 10a.

That is, the first light control layer 100' may be formed so as not to cover the entire upper surface of the light emitting device 10a while covering at least some region on a side surface of the light emitting unit 10a.

For example, an upper surface of the first light control layer 100' may be coplanar with the upper surface of the light emitting device 10a. Here, since the first light control layer 100' has roughnesses formed on the upper surface thereof, the upper surface of the first light control layer 100' may be placed higher than the upper surface of the light emitting device 10a in a remaining region A of the light emitting device 10a excluding the upper surface thereof.

Here, the upper surface of the light emitting device 10a may be placed between the highest surface r1 and the lowest surface r2 on the upper surface of the first light control layer 100'. That is, in the remaining region A of the light emitting unit 10a excluding the upper surface thereof, the height of the highest surface r1 of the first light control layer 100' may be higher than the height of the light emitting device 10a and the height of the lowest surface r2 of the first light control layer 100' may be lower than the height of the light emitting device 10a. In other words, the height H1 of the first light control layer 100' on the highest surface r1 thereof corresponds to the maximum height of the first light control layer 100' and the height H1 of the first light control layer 100' on the lowest surface r2 thereof corresponds to the minimum height of the first light control layer 100'. Accordingly, the height h of the light emitting device 10a may be between the maximum height of the first light control layer 100' and the minimum height thereof.

In another example, the height H1 of the first light control layer 100' may be in the range of 80% to 100% of the height h of the light emitting device 10a.

Here, the height H1 of the first light control layer 100' on the highest surface r1 thereof corresponds to the maximum height of the first light control layer 100' and may be the same as or lower than the height h of the light emitting device 10a. In other words, the maximum height H1 of the first light control layer 100' may be the same as or lower than the height h of the light emitting device 10a.

For example, when the light emitting device 10a has a height h of about 170 µm, the height H1 of the first light control layer 100' may be about 150 µm. Likewise, when the light emitting device 10a has a height h of about 120 µm, the height H1 of the first light control layer 100' may be about 100 µm.

Here, the first light control layer 100' may cover the entirety of the side surface of the light emitting device 10a or may be formed to a lower height H1 than the light emitting device 10a so as not to cover a portion of an upper region on the side surface of the light emitting device 10a.

As the first light control layer 100' is disposed to cover at least some region on the side surface of the light emitting device 10a without covering the upper surface of the light emitting device 10a, light generated from the light emitting device 10a and traveling to the side surface thereof can be guided to be reflected and emitted upwards by the first light control layer 100'. As a result, the light emitting apparatus according to this embodiment can improve luminous efficacy and luminance through increase in light extraction efficiency in the upward direction.

A lower portion of the light emitting device 10a, that is, a space between the connection electrodes 22, 32, may also be filled with the first light control layer 100'. Accordingly, when light generated from the light emitting device 10a travels downwards, the first light control layer 100' may guide light to be emitted upwards by reflecting the light. Accordingly, the first light control layer 100' can assist in improvement in light extraction efficiency and luminance uniformity.

Although FIG. 4A shows that the first light control layer 100' exposes the entirety of the upper surface of the light emitting device 10a, the first light control layer 100' may be formed to expose only a portion of the upper surface of the light emitting device 10a.

By way of example, the first light control layer 100' exposes a central region of the upper surface of the light emitting device 10a and may extend to a periphery of the upper surface of the light emitting device 10a to overlap at least a portion of the periphery (edge) of the upper surface of the light emitting device 10a.

In FIG. 4A, the shapes and features of the light emitting device 10a are the same as those of the first to third embodiments described above and detailed description thereof will be omitted. In the fourth embodiment, a light emitting device 10b, which is a stack type semiconductor layer including the multiple light emitting stacks described above in the first embodiment, may be disposed inside the first light control layer. Accordingly, a light emitting diode emitting red light, a light emitting diode emitting green light and a light emitting diode emitting blue light may be disposed together, thereby realizing a display apparatus that can realize RGB trichromatic colors through pixels.

Further, in the fourth embodiment, since the height H1 of the first light control layer 100' is the same as or lower than the height h of the light emitting device 10a, the overall thickness of the display apparatus can be reduced. Accordingly, this structure may be advantageous in implementation of a slimmer display apparatus with a thin thickness.

The light emitting apparatus according to this embodiment may further include a second light control layer 200 on the first light control part 100' to spread light. Further, a third light control layer 300 for prevention of eye glare may be disposed on the second light control layer 200. The second light control layer 200 and the third light control layer 300 are the same as those of the first to third embodiments and thus detailed description thereof will be omitted.

Next, FIG. 4B is a sectional view of another exemplary embodiment of the light emitting apparatus shown in FIG. 4A.

Referring to FIG. 4B, a light emitting apparatus 9000 may include a second light control layer 200 on a light emitting device 10a and a first light control layer 100', and may further include an anti-glare layer 400 on the second light control layer 200 instead of the third light control layer 300. The light emitting apparatus shown in FIG. 4B is the same as the light emitting apparatus shown in FIG. 4A except that the light emitting apparatus includes the anti-glare layer 400 instead of the third light control layer 300. Further, description of the anti-glare layer 400 is the same as that of the first to third embodiments and thus detailed description thereof will be omitted herein.

The light emitting device shown in FIG. 4B may have the same features and shape as the light emitting device 10a; 10b of the first embodiment. Multiple light emitting devices 10a may be arranged in the lateral direction and each of the light emitting devices 10a may be a stack type semiconductor layer including first to third light emitting stacks. Accordingly, a light emitting diode emitting red light, a light emitting diode emitting green light and a light emitting diode emitting blue light may be disposed together. As a result, a display apparatus capable of displaying RGB trichromatic colors through pixels can be realized.

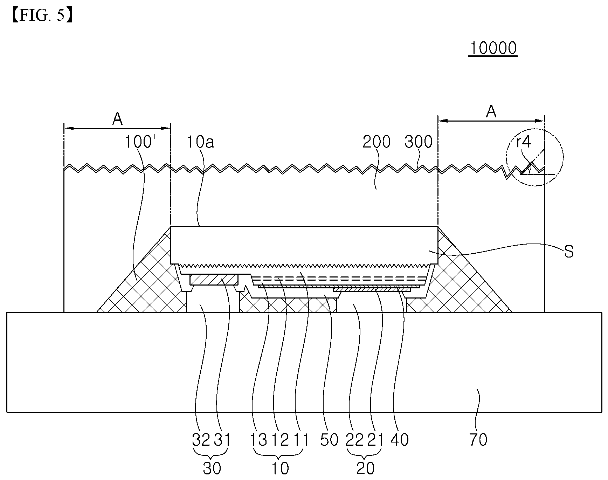

FIG. 5 is a sectional view of a light emitting apparatus according to a fifth embodiment of the present invention.

Referring to FIG. 5, in a light emitting apparatus 10000 according to this embodiment, a first light control layer 100' may have a different structure from the first light control layer 100; 100' according to the first to fourth embodiments in that the first control layer 100' surrounds a side surface of a light emitting device 10a; 10b and is formed with a slanted surface or a curved surface in at least some region thereof. In the fifth embodiment, the first light control layer 100' may be formed in various shapes so long as the first light control layer 100' covers at least some region on the side surface of the light emitting device 10a.

Specifically, the first light control layer 100' may surround the side surface of the light emitting device 10a while exposing at least part of the upper surface of the light emitting device 10a, in which the first light control layer 100' may have a slanted surface or a curved surface in at least some region thereof.

The slanted surface or the curved surface of the first light control layer 100' may be formed on the side surface of the first light control layer 100' to form a downward inclination by which the height of the first light control layer 100' is decreased with increasing distance from the light emitting device 10a.

By way of example, the first light control layer 100' may include at least some zones having different horizontal cross-sectional areas depending on the height thereof. Likewise, the first light control layer 100' may include at least some zones having different vertical cross-sectional areas depending on a distance to the side surface of the light emitting device 10a.

Specifically, the first light control layer 100' may include at least some zones having a horizontal cross-sectional area gradually increasing from an upper portion thereof to a lower portion thereof. Alternatively, the first light control layer 100' may include at least some zones having a horizontal cross-sectional area gradually decreasing from the upper portion thereof to the lower portion thereof. Alternatively, the first light control layer 100' may include at least some zones having a constant horizontal cross-sectional area from the upper portion thereof to the lower portion thereof.

Preferably, the first light control layer 100' has a combination of at least some zones having a horizontal cross-sectional area gradually increasing from the upper portion thereof to the lower portion thereof and at least some zones having a horizontal cross-sectional area gradually decreasing from the upper portion thereof to the lower portion thereof, a combination of at least some zones having a horizontal cross-sectional area gradually increasing from the upper portion thereof to the lower portion thereof and at least some zones having a constant horizontal cross-sectional area from the upper portion thereof to the lower portion thereof, or a combination of at least some zones having a horizontal cross-sectional area gradually increasing from the upper portion thereof to the lower portion thereof, at least some zones having a horizontal cross-sectional area gradually decreasing from the upper portion thereof to the lower portion thereof, and at least some zones having a constant horizontal cross-sectional area from the upper portion thereof to the lower portion thereof.

In another example, the first light control layer 100' may have at least some zones having different heights depending on the distance to the side surface of the light emitting device 10a. In other words, the first light control layer 100' may include at least some zones having different vertical cross-sectional areas depending on the distance to the side surface of the light emitting device 10a.

Specifically, the first light control layer 100' may include at least some zones having a height gradually decreasing with increasing distance from the side surface of the light emitting device 10a. Alternatively, the first light control layer 100' may include at least some zones having a height gradually increasing with increasing distance from the side surface of the light emitting device 10a. Alternatively, the first light control layer 100' may include at least some zones having a constant height with increasing distance from the side surface of the light emitting device 10a.

Preferably, the first light control layer 100' includes a combination of at least some zones having a vertical cross-sectional area gradually decreasing with increasing distance from the light emitting device 10a and at least some zones having a vertical cross-sectional area gradually increasing with increasing distance from the light emitting device 10a, a combination of at least some zones having a vertical cross-sectional area gradually decreasing with increasing distance from the light emitting device 10a and at least some zones having a constant vertical cross-sectional area with increasing distance from the light emitting device 10a, or a combination of at least some zones having a vertical cross-sectional area gradually decreasing with increasing distance from the light emitting device 10a, at least some zones having a vertical cross-sectional area gradually increasing with increasing distance from the light emitting device 10a and at least some zones having a constant vertical cross-sectional area with increasing distance from the light emitting device 10a.

Further, the slanted surface or the curved surface formed in at least some region of the first light control layer 100' may have various inclinations depending on the location thereof.

It should be understood that the first light control layer 100' is not required to expose the entire upper surface of the light emitting device 10a and may be formed to cover the upper surface of the light emitting device 10a including the periphery thereof.

Further, the first light control layer 100' may be formed to have a maximum height lower than the upper surface of the light emitting device 10a so as to partially surround a lower portion of the side surface of the light emitting device 10a, or may be formed to have a maximum height coplanar with the upper surface of the light emitting device 10a so as to surround the entirety of the side surface of the light emitting device 10a.

Although FIG. 5 shows that the first light control layer 100' may be linearly formed in a downwardly slanted shape from a point (upper surface edge thereof) at which the upper surface of the light emitting device 10a meets the side surface thereof to a lower bottom (lower end) of the light emitting device 10a (that is, to the upper surface of the substrate on which the light emitting device 10a is disposed), an upper start point of the first light control layer 100' may be higher or lower than the upper surface of the light emitting unit 10a, and the slated surface or the curved surface formed in at least some region of the first light control layer 100' may have various shapes, for example, a concave shape or a convex shape, due to effects of surface tension depending on conditions, such as the properties, composition and volumes, of materials of the first light control layer 100', as described above.

In addition, as described above, the first light control layer 100' may be disposed such that the lower portion of the light emitting device 10a, that is, the space between the connection electrodes 22, 32 of the light emitting device 10a, can be filled with the first light control layer 100'. The first light control layer 100', that is, the reflective material, may be disposed on the side surface and lower portion of the light emitting device 10a to guide light emitted from the side surface and the lower portion of the light emitting device 10a to travel upwards, thereby improving light extraction efficiency and luminance.

Further, the second light control layer 200 may be disposed on the first light control layer 100' and the light emitting device 10a, and the third light control layer 300 may be disposed on the second light control layer 200.

Although not shown in the drawings, an anti-glare layer 400 may be disposed on the second light control layer 200 instead of the third light control layer 300.

In the fifth embodiment, the light emitting device 10a, the second and third light control layers 200, 300 and the anti-glare layer 400 may have the same or similar configuration to those of the first to fourth embodiments described above and thus detailed description thereof will be omitted.

Although FIG. 1A to FIG. 5 show one light emitting device 10a disposed on one surface of the substrate 70, it should be understood that multiple light emitting devices 10a may be disposed on one surface of the substrate 70. The length, width, and height of the substrate 70 may be set in various ways, as needed. When the multiple light emitting devices 10a are disposed on one surface of the substrate 70, the multiple light emitting devices 10a may be spaced apart from each other.

The light emitting apparatuses 1000, 2000, 3000, 4000, 5000, 6000, 7000, 8000, 9000, 10000 according to the present invention may constitute a display apparatus.

Specifically, the light emitting apparatuses 1000, 2000, 3000, 4000, 5000, 6000, 7000, 8000, 9000, 10000 may be display modules and the display apparatus may include at least one display module.

The display module may be the same as or similar to the light emitting apparatuses 1000, 2000, 3000, 4000, 5000, 6000, 7000, 8000, 9000, 10000 according to the first to fifth embodiments of the present invention.

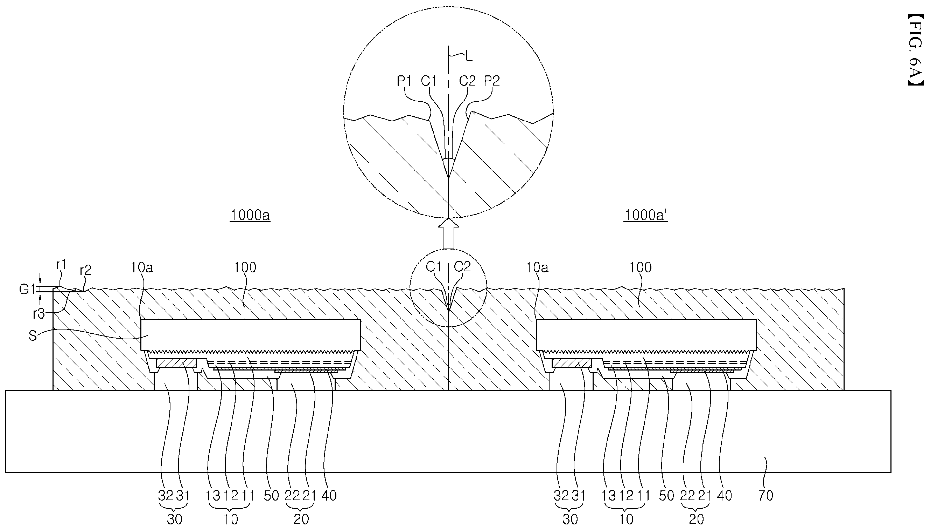

Specifically, the display apparatus may include at least one display module. The display module may include a substrate 70, at last one light emitting device 10a disposed on one surface of the substrate 70, and a first light control layer 100 covering at least part of the light emitting device 10a. FIG. 6A is a sectional view of a display apparatus according to a sixth embodiment of the present invention, which may include a first light emitting apparatus 1000a and a second light emitting apparatus 1000a' arranged side by side in a lateral direction thereof.

In the display apparatus, a side surface of the first light emitting apparatus 1000a may adjoin a side surface of the second light emitting apparatus 1000a', and a V-shaped groove may be formed at an interface between the two light emitting apparatuses 1000a, 1000a'. Here, the V-shaped groove may be formed by cutting the light emitting apparatuses.

Certain angles C1, C2 may be formed between the first light emitting apparatus 1000a and the second light emitting apparatus 1000a' by the V-shaped groove and may be defined as bevel angles of the V-shaped groove.

Here, the bevel angles may mean angles defined by machined surfaces P1, P2 of the first and second light emitting apparatuses 1000a, 1000a' and an imaginary plane L perpendicular to upper surfaces of the first and second light emitting apparatuses 1000a, 1000a in the V-shaped groove formed at the interface between the first light emitting apparatus 1000a and the second light emitting apparatus 1000a'.

The V-shaped groove may have beveled angles C1, C2 of 40° or less, preferably 1° to 20°.

In the V-shaped groove, a bevel angle C1 with reference to a side surface P1 of the first light emitting apparatus 1000a may be the same as a bevel angle C2 with reference to a side surface P2 of the second light emitting apparatus 1000a', without being limited thereto. Alternatively, the two bevel angles C1, C2 may be different from each other. When the bevel angles C1, C2 of the V-shaped groove are different from each other, a difference between the bevel angles C1, C2 of the V-shaped groove may be 10° or less.

The V-shaped groove may have various depths. By way of example, the lowermost end of the V-shaped groove may be placed above the upper surface of the light emitting device 10a in the light emitting apparatuses 1000a, 1000a'. However, it should be understood that the present invention is not limited thereto and the V-shaped groove may extend beyond the upper surface of the light emitting device 10a to a lower portion thereof.

In the V-shaped groove, the bevel angles C1, C2 are formed at an interface between adjoining side surfaces of the first light emitting apparatus 1000a and the second light emitting apparatus 1000a' and may be set in various ways.

The side surfaces P1, P2 of the light emitting apparatuses 1000a, 1000a' forming the V-shaped groove therebetween may form flat surfaces, without being limited thereto. Alternatively, the side surfaces P1, P2 may include rough surfaces in at least some region thereof. The side surfaces P1, P2 of the light emitting apparatuses 1000a, 1000a' forming the V-shaped groove therebetween may have different lengths.

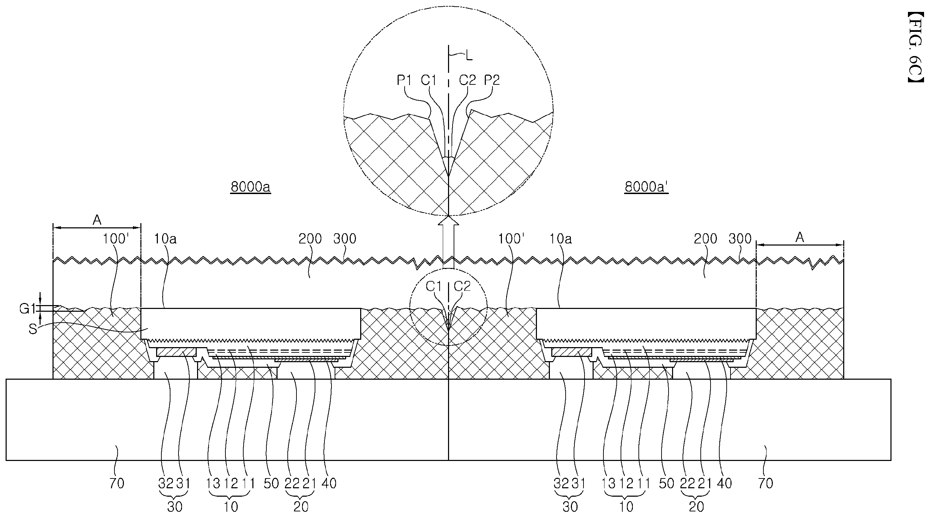

Although FIG. 6A shows one embodiment of the display apparatus in which the substrate 70 of the first light emitting apparatus 1000a is integrated with the substrate 70 of the second light emitting apparatus 1000a', it should be understood that the substrate 70 of the first light emitting apparatus 1000a and the substrate 70 of the second light emitting apparatus 1000a' may be different members placed to adjoin each other, as shown in FIG. 6C.

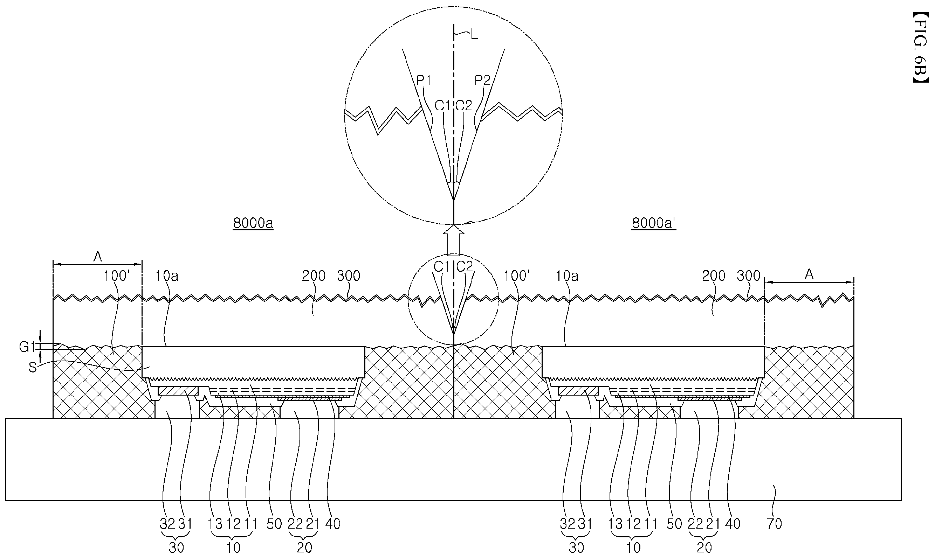

FIG. 6B shows another exemplary embodiment of the display apparatus shown in FIG. 6A. Specifically, unlike FIG. 6A, FIG. 6B shows cross-sections of a third light emitting apparatus 8000a and a fourth light emitting apparatus 8000a', each of which further includes at least two light control layers 200, 300, for example, first to third light control layers 100', 200, 300, or an anti-glare layer 400.

Referring to FIG. 6B, a V-shaped groove may be formed at an interface between adjoining side surfaces of the third light emitting apparatus 8000a and the fourth light emitting apparatus 8000a' and may have certain angles C1, C2. Here, the shape and features of the V-shaped groove and the angles C1, C2 are the same as or similar to those of the V-shaped groove shown in FIG. 6A and detailed description thereof will be omitted.

Referring to FIG. 6B, since each of the light emitting apparatuses includes multiple light control layers 100', 200, 300, the V-shaped groove may be formed in the second and third light control layers 200, 300. Alternatively, although not shown in the drawings, the V-shaped groove may extend downwards to some region of the first light control layer 100'.

In addition, although not shown in the drawings, each of the light emitting apparatuses 8000a, 8000a' may include the anti-glare layer 400 instead of the third light control layer 300. In this embodiment, the V-shaped groove may be formed in the anti-glare layer 400 and the second light control layer 200, or may further extend downwards to some region of the first light control layer 100'.

FIG. 6C shows another exemplary embodiment of the display apparatus shown in FIG. 6B. Specifically, unlike FIG. 6B, FIG. 6C shows that the other light control layers 200, 300 or the anti-glare layer 400 are formed on the light emitting apparatuses after the light emitting apparatuses each including only the first light control layer 100' are disposed side by side to adjoin each other.

Since the other layers are formed on the light emitting apparatuses each including only the first light control layer 100' and disposed side by side to adjoin each other, the V-shaped groove formed at the interface between the light emitting apparatus 8000a, 8000a' disposed side by side to adjoin each other may be formed in the first light control layer 100', and the other light control layers 200, 300 or the anti-glare layer 400 may cover the upper surface of the first light control layer 100' on which the V-shaped groove is formed.

Although FIG. 6C shows the structure in which the first light control layer 100', the second light control layer 200, and third light control layer 300 are sequentially formed on the upper surfaces of the light emitting apparatuses, it should be understood that the present invention is not limited thereto. Alternatively, instead of the third light control layer 300, the anti-glare layer 400 may be formed on the upper surfaces of the light emitting apparatuses to perform the same function as the third light control layer 300.

Alternatively, although not shown in the drawings, the other light control layer 300 or the anti-glare layer 400 may be formed on the light emitting apparatuses 8000a, 8000a' after the light emitting apparatuses 8000a, 8000a' each including the first light control layer 100' and the second light control layer 200 are disposed side by side to adjoin each other. Since the other light control layer 300 or the anti-glare layer 400 is formed on the light emitting apparatuses 8000a, 8000a' after the light emitting apparatuses 8000a, 8000a' each including the first light control layer 100' and the second light control layer 200 are disposed side by side to adjoin each other, the V-shaped groove formed at the interface between the light emitting apparatus 8000a, 8000a' may be formed in the second light control layer 200 or may extend to the first light control layer 100 and the other light control layer 300 or the anti-glare layer 400 may be formed to cover the upper surface of the second light control layer 200 on which the V-shaped groove is formed.

Although FIG. 6A to FIG. 6C shows the display apparatuses in which two light emitting apparatuses (that is, display modules) are disposed to adjoin each other, it should be understood that the present invention is not limited thereto and the display apparatus may include three or more light emitting apparatuses.

Referring to FIG. 6A to FIG. 6C, the multiple light emitting apparatuses having the angles C1, C2 formed at the interface between the adjoining side surfaces thereof are disposed side by side to emit light in an outward direction of the display apparatus. Accordingly, the angles C1, C2 formed at the interface between the multiple light emitting apparatuses upon attachment (tiling) of the multiple light emitting apparatuses to each other can suppress generation of a white line (or dark line) at a connecting portion (seam) between the light emitting apparatuses, thereby realizing a display apparatus having improved luminance.

Although some exemplary embodiments have been described herein with reference to the accompanying drawings, it should be understood that various modifications and changes can be made by those skilled in the art or by a person having ordinary knowledge in the art without departing from the spirit and scope of the present invention defined by the claims and equivalents thereto.

Therefore, the scope of the present invention should be defined by the appended claims and equivalents thereto rather than by the detailed description of the invention.

## Claims

1. A light emitting apparatus comprising:
at least one light emitting device; and
a first light control layer allowing light transmission therethrough and covering at least part of the light emitting device,
wherein the first light control layer has at least one protrusion formed in at least some region on an upper surface thereof and a height difference G1 between a maximum height and a minimum height of the at least one protrusion is 40 µm or less.

2. The light emitting apparatus according to claim 1, further comprising:
a second light control layer disposed on the first light control layer and allowing light transmittance therethrough.

3. The light emitting apparatus according to claim 2, wherein the second light control layer has at least one protrusion formed in at least some region on an upper surface thereof.

4. The light emitting apparatus according to claim 2, wherein the second light control layer comprises a light diffusive material for spreading of light.

5. The light emitting apparatus according to claim 4, wherein the second light control layer has a thickness of 100 µm to 300 µm.

6. The light emitting apparatus according to claim 2, wherein a height of the first light control layer is in the range of 80% to 100% of a height of the light emitting device.

7. The light emitting apparatus according to claim 2, wherein the first light control layer covers an upper surface of the light emitting device.

8. The light emitting apparatus according to claim 7, wherein a thickness from the upper surface of the light emitting device to the upper surface of the first light control layer is smaller than the height difference G1.

9. The light emitting apparatus according to claim 2, wherein the first light control layer exposes at least part of an upper surface of the light emitting device.

10. The light emitting apparatus according to claim 9, wherein the first light control layer comprises at least one of a light blocking material or a light reflective material.

11. The light emitting apparatus according to claim 9, wherein the first light control layer exposes a central region of the upper surface of the light emitting device and overlaps at least part of an upper surface periphery of the light emitting device.

12. The light emitting apparatus according to claim 9, wherein the first light control layer surrounds at least part of a side surface of the light emitting device and has a slanted surface or a curved surface formed in at least some region thereof.

13. The light emitting apparatus according to claim 2, further comprising: a third light control layer disposed on the second light control layer.

14. The light emitting apparatus according to claim 13, wherein the third light control layer has at least one protrusion formed in at least some region on an upper surface thereof.

15. The light emitting apparatus according to claim 13, wherein the third light control layer is a film attached to an upper surface of the second light control layer and has a thickness of 1 µm or less.

16. The light emitting apparatus according to claim 2, further comprising: an anti-glare layer disposed on the second light control layer.

17. The light emitting apparatus according to claim 16, further comprising:
a bonding layer bonding the anti-glare layer to an upper surface of the second light control layer,
wherein the anti-glare layer is an anti-glare film attached to the upper surface of the second light control layer.

18. A display apparatus comprising:
a substrate;
at least one light emitting device disposed on one surface of the substrate; and
a first light control layer covering at least part of the light emitting device,
wherein the first light control layer has at least one protrusion formed in at least some region on an upper surface thereof, and
a difference between a maximum height and a minimum height of the at least one protrusion is 40 µm or less.

19. A display apparatus comprising:
a substrate;
at least one light emitting device disposed on one surface of the substrate; and
a first light control layer covering at least part of the light emitting device,
wherein the first light control layer has a slanted surface or a curved surface formed in at least some region thereof.

20. The display apparatus according to claim 19, wherein the first light control layer has at least some zones having different horizontal cross-sectional areas depending on a height thereof.

21. The display apparatus according to claim 19, wherein the first light control layer has at least some zones having different heights depending on a distance to a side surface of the light emitting device.
